# EUROPÄISCHE PATENTANMELDUNG

(11) **EP 3 731 268 A1**
(43) Veröffentlichungstag der Anmeldung: **28.10.2020**
(21) Anmeldenummer: 19171243.9
(22) Anmeldetag: 26.04.2019
(51) Int. Cl.: H01L 23/373, H01L 23/473, H01L 21/48, H01L 23/367

(54) **MIKROKÜHLKÖRPER**

(71) Anmelder: IQ evolution GmbH, 52074 Aachen (DE)
(72) Erfinder: Ebert, Thomas, 52146 Würselen (DE)
(74) Vertreter: Paul & Albrecht Patentanwälte PartG mbB

(57) **Zusammenfassung**

Die vorliegende Erfindung betrifft einen Mikrokühlkörper (1) mit mindestens einer Montagefläche (2) für ein zu kühlendes Bauteil, insbesondere ein Halbleiterbauelement, welcher im Inneren eine Mikrokühlstruktur (3) aufweist, die über Verbindungskanäle (4) mit mindestens einer Zulauföffnung (5) und mindestens einer Ablauföffnung (6) verbunden ist und mit diesen ein innerhalb des Mikrokühlkörpers ausgebildeten Kühlkreislauf bilden, über den der Mikrokühlstruktur (3) ein Kühlmedium zuführbar beziehungsweise aus ihr abführbar ist, wobei der Mikrokühlkörper (1) eine monolithische Struktur aufweist, dadurch gekennzeichnet, dass an der Montagefläche (2) eine Isolierschicht (7) vorgesehen ist, die mittels einer Klebeschicht (8) mit der Montagefläche (2) verbunden ist.

## Beschreibung

Die vorliegende Erfindung betrifft einen Mikrokühlkörper mit mindestens einer Montagefläche für ein zu kühlendes Bauteil, insbesondere ein Halbleiterbauelement, welcher im inneren eine Mikrokühlstruktur aufweist, die über Verbindungskanäle mit mindestens einer Zulauföffnung und mindestens einer Ablauföffnung verbunden ist und mit diesen ein innerhalb des Mikrokühlkörpers ausgebildeten Kühlkreislauf bilden, über den der Mikrokühlstruktur ein Kühlmedium zuführbar bzw. aus ihr abführbar ist, wobei der Mikrokühlkörper eine monolithische Struktur aufweist.

Mikrokühlkörper der oben genannten Art sind bekannt und beispielsweise in der EP 1 672 690 B1 beschrieben. Der darin beschriebene Mikrokühlkörper ist aus einer monolithischen Struktur hergestellt, um Fugen, wie sie in schichtförmig aufgebauten Mikrokühlkörpern vorhanden sind, zu vermeiden und so Dichtigkeitsproblemen entgegentreten zu können. Ferner ermöglicht die monolithische Struktur des Mikrokühlkörpers gemäß dem Stand der Technik, die benötigte Mindestaußenwandstärke des Mikrokühlkörpers gegenüber Wandstärken der bekannten Kupferwärmsenken, wie beispielsweise mittels des direct copper Bondigs hergestellte Mikrokühlkörper stark zu verringern, sodass eine wesentlich größere Überdeckung zwischen dem Bereich, durch den ein Kühlmedium, beispielsweise deionisiertes Wasser, für einen Wärmeaustausch fließen kann, und den Bereich, in dem die elektronischen Bauelemente angeordnet sind, erreicht wird.

Ein solcher monolithischer Aufbau kann beispielsweise mittels des selektiven Laserschmelzens hergestellt werden. Durch das Verfahren des selektiven

Laserschmelzens wird es möglich, beliebige monolithische, dreidimensionale Formen und Strukturen auch innerhalb des Mikrokühlkörpers insbesondere hinsichtlich der Mikrokühlstruktur zu erzeugen. Die mit dem Mikrokühlkörper zu kühlenden Bauteile wie beispielsweise Hochleistungsdiodenlaser aus Galliumarsenid werden im Stand der Technik auf den Mikrokühlkörper aufgelötet, um einen elektrischen Kontakt zur Kühleroberfläche zu erhalten. Dabei ist es üblich, nur ein nicht elektrisch leitendes Kühlmedium zu verwenden. Dieser Prozess ist gerade bei der Herstellung von Platinen als sehr aufwendig einzuschätzen. Ebenso kann das Aufbringen einer elektrischen Schaltung ein Problem darstellen. Ferner erfahren die aufzulötenden Bauteile durch den Lötprozess eine Art Wärmebehandlung, welche aufgrund der unterschiedlichen Wärmeausdehnungskoeffizienten zwischen Mikrokühlkörper und den aufzulötenden Bauteilen Spannungen und Verzug zwischen letzterem erzeugen können.

Es ist daher Aufgabe der vorliegenden Erfindung, einen Mikrokühlkörper sowie eine Platine und ein Diodenlaserbauelement als auch ein Verfahren zu deren Herstellung bereitzustellen, die eine einfachere und schonendere Verbindung zwischen den zu montierenden Bauteilen ermöglicht.

Diese Aufgabe wird erfindungsgemäß dadurch gelöst, dass an der Montagefläche des Mikrokühlkörpers eine Isolierschicht vorgesehen ist, die mittels einer Klebeschicht mit der Montagefläche verbunden ist.

Mit anderen Worten basiert die Erfindung auf dem Grundgedanken, einen dreidimensional gedruckten Mikrokühlkörper bereitzustellen, diesen mit einer geeigneten Isolationsschicht zu versehen und mit Leiterbahnen zu versehen. Daraus ergibt sich eine Platineneinheit, in der Kühlflächen und Dimension des Mikrokühlkörpers sich im Einklang mit der elektrischen Schaltung befindet. Es wird also ermöglicht, eine gekühlte Einheit, bestehend aus Mikrokühlkörper und Platine, als auch ein Verfahren zu deren Herstellung bereitzustellen, bei der elektrische Komponenten direkt auf den Mikrokühlkörper beziehungsweise die Isolierschicht aufgebracht werden können.

Dabei kann sich anbieten, dass die Isolierschicht aus einer Keramik, einer Glaskeramik, einem Keramik-gefüllten Kunststoff, PTFE oder Glasfaserverstärkten Kunststoff auf Epoxidbasis gebildet ist.

Die Isolierschicht kann bevorzugt durch eine Keramik gebildet sein, was den Herstellungsprozess je nach Anwendungsfall einfacher und wesentlich flexibler gestalten lässt.

Um eine möglichst gute Wärmeleitfähigkeit zu erreichen, kann es vorteilhaft sein, eine wärmeleitende Klebeschicht zur Verbindung der Isolierschicht mit der Montagefläche zu wählen.

Bei Verwendung von Glaskeramik in Kombination mit einem Bindemittel kann es zweckmäßig sein, den Mikrokühlkörper anschließend einem Brennvorgang mit großer Erwärmung auszusetzen, wodurch das Bindemittel im fertigen Bauteil nahezu komplett aus der Keramikfolie oder der Glaskeramik verdampft, und die verbleibenden Keramikbestandteile zur eigentlichen Keramik gebrannt werden kann.

Eine besonders bevorzugte Ausführungsform der vorliegenden Erfindung sieht vor, dass die Isolierschicht auflaminiert ist, wobei sie elektrisch leitfähige Strukturen aufweist, welche mittels Siebdruck, Inkjet-Verfahren oder Dispensionsverfahren auf die Isolierschicht aufgebracht werden können.

Eine weitere Ausführungsform der vorliegenden Erfindung sieht eine Platine, insbesondere eine Hochfrequenzplatine vor, welche mindestens einen Kühlabschnitt mit mindestens einem erfindungsgemäßen Mikrokühlkörper aufweist.

Zweckmäßigerweise kann an der Platine eine Isolierschicht mit einer Dicke zwischen 12 µm und 1000 µm, bevorzugt 50 µm bis 100 µm noch bevorzugter eine Schichthöhe von 60 µm aufweisen, um so einen möglichst geringen Platzbedarf im Einbau der Platine in entsprechenden elektronischen Bauelementen zu erreichen und den für die Kühlung negativen Einfluss der Isolationsschicht zu begrenzen.

Um eine verbesserte Wärmeabfuhr an den Kühlabschnitten zu erreichen, kann die Isolierschicht sich an der Montagefläche um den Kühlabschnitt herum erstrecken. Die Isolierschicht wird so nur teilweise an der Montagefläche angebracht. Die Kühlabschnitte selbst können so in direktem Kontakt mit den zu kühlenden Bauteilen gelangen, ohne dass deren elektrische Kontakte unmittelbar mit der Kühleroberfläche in Berührung kommen.

Alternativ ist es natürlich auch möglich, dass die Isolierschicht den Mikrokühlkörper vollständig oder nahezu vollständig überdeckt, was den Herstellungsprozess vereinfachen kann.

In einem Ausführungsbeispiel der vorliegenden Erfindung ist vorgesehen, dass der Mikrokühlkörper zur Bildung eines Kühlabschnittes der Platine von einem Material mit kleiner oder geringer Wärmeleitfähigkeit insbesondere aus Keramik-gefülltem Kunststoff, PTFE oder glasfaserverstärktem Kunststoff umgeben sein kann.

In einem alternativen Ausführungsbeispiel ist der Mikrokühlkörper nicht in ein Material mit kleiner oder geringer Wärmeleitfähigkeit eingesetzt, sondern bildet gleichzeitig die Oberfläche, mit der die Isolierschicht insbesondere mittels einer Klebeschicht vollständig oder nahezu vollständig überdeckt ist.

In einem weiteren Ausführungsbeispiel der vorliegenden Erfindung kann die Mikrokühlstruktur innerhalb des Mikrokühlkörpers durch Stabrippen gebildet sein, welche vorzugsweise quer zu einer Strömungsrichtung innerhalb der Mikrokühlstruktur ausgerichtet sein kann. Eine Erstreckung der Stabrippen quer zur Strömungsrichtung innerhalb des Mikrokühlkörpers sorgt für turbulente Strömung. Ferner wird das Risiko einer Blockade verringert, welche durch das durch den Kühlkreislauf strömende Kühlmedium, beispielsweise durch Pulverreste entstehen können. Auch wird durch solch eine Ausrichtung der Stabrippen 3a eine Stützfunktion der Wandungen des Mikrokühlkörpers erreicht.

Um möglichst eine turbulente Strömung innerhalb der Mikrokühlstruktur erreichen zu können, kann es sich anbieten, die Zulauföffnung mit einer verminderten Höhe zwischen 15 µm und 250 µm, bevorzugt von 20 µm auszugestalten. Durch die deutlich verminderte Höhe gegenüber den übrigen Kanalstrukturen, welche eine Höhe von ungefähr 350 µm aufweisen, ergibt sich eine deutlich turbulentere Strömung innerhalb der Mikrokühlstruktur.

Dies kann noch weiter gefördert werden, indem innerhalb des Kühlbereichs eine Oberflächenrauhigkeit von 25 µm in den Kühlkanälen vorgesehen wird, wobei außerhalb des Kühlkreislaufes eine wesentlich glattere Oberfläche vorgesehen sein kann. Außerhalb des Kühlbereichs kann eine glattere Oberfläche vorgesehen sein, welche in Kombination mit der gesteigerten Höhe eine laminare Strömung ermöglicht.

Eine besonders bevorzugte Ausführungsform der vorliegenden Erfindung sieht vor, den Mikrokühlkörper aus Nickel, Kupfer, Edelstahl oder Molybdän zu fertigen, was einen bevorzugten Einbau in ein erfindungsgemäßes Diodenlasersbauelement mit sich bringt.

Um ein Diodenlaserbauelement mit mindestens einer erfindungsgemäßen Platine herstellen zu können, wird folgendes Verfahren vorgeschlagen:
- Herstellung des Mikrokühlkörpers mittels des selektiven Laserschmelzens zur Bildung einer monolithischen Struktur;
- Aufbringen einer Isolierschicht auf die mindestens eine Montagefläche des Mikrokühlkörpers mittels einer insbesondere wärmeleitenden Klebeschicht; und
- Aufbringen von elektrisch leitfähigen Strukturen auf die Isolierschicht mittels Siebdruck, Inkjetverfahren oder Dispensionsverfahren.

Dazu kann es vorteilhaft sein, den mindestens einen Mikrokühlkörper quaderartig auszubilden, um ihn in eine Platinenstruktur einfach einsetzen zu können.

Zweckmäßigerweise kann die Isolierschicht unter einem Druck zwischen 150 bar und 300 bar, bevorzugt von 230 bar und einer Temperatur zwischen 60°C und 200°C, bevorzugt 140°C aufgebracht werden, wobei die Schicht aus Keramik oder aus Glaskeramik und Bindemittel gebildet sein kann. Die Glaskeramik können dabei in eine Bindemittelmatrix eingebettet werden, wobei die Platine anschließend einem Brennvorgang unterzogen wird, in welchem sie bei einer Temperatur zwischen 700°C und 1000°C, bevorzugt zwischen 850°C und 900°C gebrannt wird.

Hinsichtlich weiterer vorteilhafter Ausgestaltungen und Weiterbildungen der Erfindung wird auf die Unteransprüche sowie auf die nachfolgende Beschreibung von Ausführungsbeispielen anhand der beiliegenden Zeichnungen verwiesen.

In der Zeichnung zeigt:
- Figur 1: eine perspektivische Darstellung eines quaderförmigen Mikrokühlkörpers;
- Figur 2: eine schematische Darstellung der Mikrokühlkörper gemäß Figur 1 im Schnitt;
- Figur 3: eine Leiterplatte mit einem Mikrokühlkörper gemäß Figur 1; und
- Figur 4: eine schematische Darstellung einer Leiterplatte mit mehreren Mikrokühlkörpern.

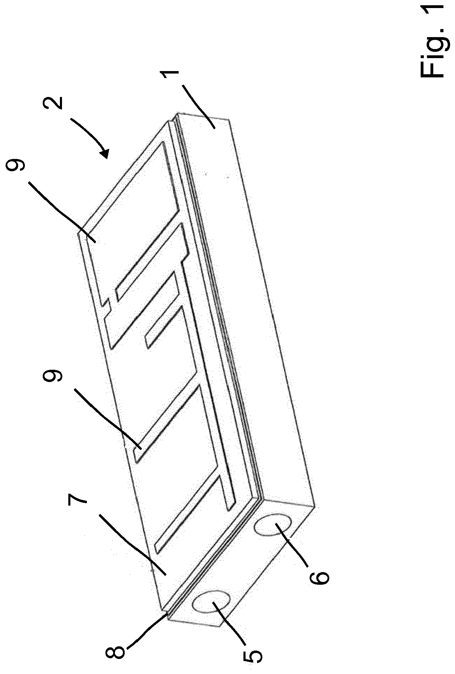

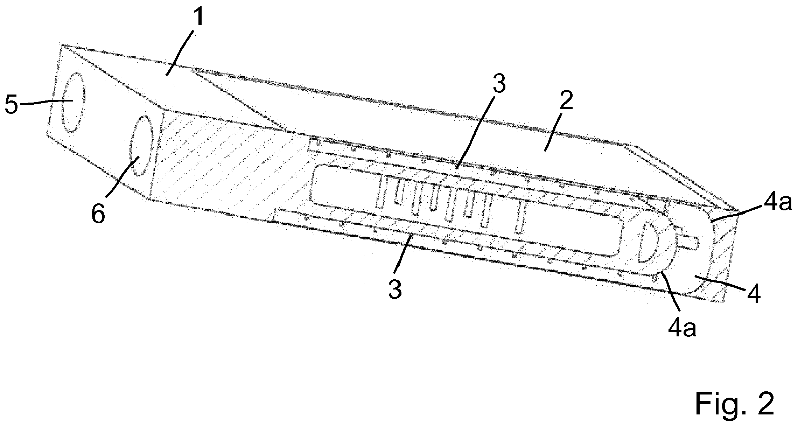

Die Figuren 1 bis 4 zeigen einen erfindungsgemäßen Mikrokühlkörper 1 mit einer Montagefläche 2 für ein zu kühlendes Bauteil wie beispielsweise ein Halbleiterbauelement.

Im Inneren weist der Mikrokühlkörper 1 eine Mikrokühlstruktur 3 auf, die über Verbindungskanäle 4 mit einer Zulauföffnung 5 und einer Ablauföffnung 6 verbunden ist. Die Mikrokühlstruktur 3 bildet zusammen mit den Verbindungskanälen 4 sowie der Zulauföffnung 5 sowie der Ablauföffnung 6 einen innerhalb des Mikrokühlkörper 1 ausgebildeten Kühlkreislauf, über den der Mikrokühlstruktur 3 ein Kühlmedium zuführbar bzw. aus ihr abführbar ist.

Der erfindungsgemäße Mikrokühlkörper 1 ist aus einer monolithischen Struktur gefertigt. An der Montagefläche 2 ist eine Isolierschicht 7 vorgesehen, welche mittels einer wärmeleitenden Klebeschicht 8 mit der Montagefläche 2 verbunden ist.

Die Isolierschicht 7 ist aus einem keramikgefüllten Kunststoff hergestellt. Alternativ ist in einem nicht dargestellten Ausführungsbeispiel die Isolierschicht aus PTFE oder glasfaserverstärktem Kunststoff auf Epoxidbasis gebildet. Auch eine Keramik ist abhängig von den äußeren Begebenheiten eine Basis für eine entsprechende Isolierschicht 7. Die Keramik ist hier aus Glaskeramik und Bindemittel gebildet. Das Bindemittel entweicht aus der Keramik, sobald der Mikrokühlkörper 1 in einem Brennofen einem Brennvorgang bei Temperaturen zwischen 600°C und 700°C unterzogen wird.

Auf der Isolierschicht 7 sind elektrisch leitfähige Strukturen 9 ausgebildet. Diese sind in diesem Ausführungsbeispiel mittels Inkjetverfahren auf die Isolierschicht 7 aufgebracht. Natürlich ist es auch möglich, die elektrisch leitfähigen Strukturen mittels Siebdruck oder Dispensionsverfahren auf die Isolierschicht 7 aufzubringen.

Wie in der Figur 1 näher zu sehen, weisen die Verbindungskanäle 4 eine strömungsoptimierte Struktur in Form von abgerundeten, insbesondere ovalen Wandungen und Grenzflächen 4a auf, so dass sich in den Verbindungskanälen 4 eine nahezu laminare Strömung ausbildet. Dadurch wird ein Druckabfall in dem den Mikrokühlkörper 1 durchströmenden Kühlmedium vermindert. Zur Mikrokühlstruktur 3 hin verringert sich der Querschnitt der Verbindungskanäle 4 zu einer Höhe zwischen 150 und 250 µm, bevorzugt 200 µm. Dadurch kann die Ausbildung einer turbulenten Strömung unterstützt werden. Ferner wird im Bereich der Mikrokühlstruktur 3 eine Oberflächenrauhigkeit von ca. 25 µm eingestellt, was die Ausbildung von turbulenter Strömung unterstützt.

Die Mikrokühlstruktur 3 innerhalb des Mikrokühlkörpers weist Stabrippen 3a auf, welche quer zu einer Strömungsrichtung innerhalb der Mikrokühlstruktur 3 ausgerichtet sind. Durch die Ausrichtung quer zur Strömungsrichtung wird neben der Verstärkung der turbulenten Strömung durch die Stabrippen 3a gleichzeitig die Wandungen um die Mikrokühlstruktur 3 herum gestützt.

Der Mikrokühlkörper 1 ist mittels des selektiven Laserschmelzens hergestellt. Bei diesem Verfahren wird das herzustellende Bauteil zunächst entlang einer Z-Ebene des Bauteils virtuell in Schnitte zerlegt, und die sich daraus ergebenden CAD-Daten in X- und Y-Richtung werden in eine Steuereinheit eingegeben. Anschließend wird ein metallisches Werkstoffpulver beispielsweise aus Nickel, Kupfer, Edelstahl oder Molybdän frei von Bindemitteln und Flussmitteln mit einer vorgegebenen Schichthöhe, die eine Eindringtiefe eines in dem Verfahren eingesetzten Laserstrahls entspricht, auf eine in Z-Richtung versenkbare Bodenplatte einer Prozesskammer aufgebracht.

Unter Schutzgasatmosphäre wird ein Laserstrahl entsprechend der in die Steuereinheit eingegebenen CAD-Daten auf der Pulverschicht verfahren, so dass das metallische Werkstoffpulver lokal auf Schmelztemperatur erhitzt und an der jeweiligen Auftreffstelle des Laserstrahls über seine gesamte Schichthöhe vollständig aufgeschmolzen wird.

Anschließend wird die Bodenplatte um einen Betrag abgesenkt, der der Schichtdicke des eingefüllten Metallpulvers entspricht. Dann wird eine weitere Schicht aus dem metallischen Werkstoffpulver auf die bereits vorhandene, mit Laserstrahlung behandelte Metallpulverschicht aufgebracht, deren Schichtdicke wiederum der Eindringtiefe des Laserstrahls entspricht.

Danach wird der Laserstrahl erneut entsprechend der in der Steuerung eingegebenen CAD-Daten des herzustellenden Mikrokühlkörpers in X- und Y-Richtung verfahren und das Material an der Auftreffstelle des Laserstrahls wiederum über seine gesamte Schichtdicke vollständig aufgeschmolzen. Diese Vorgehensweise wird so lange wiederholt, bis der Mikrokühlkörper vollständig strukturiert und aufgebaut ist.

Der Laserstrahl wird mit mehreren Spuren über den vorgegebenen Bereich der Werkstoffschicht so geführt, dass jede folgende Spur des Laserstrahls die vorherige Spur teilweise überlappt. Durch die Überlappung wird die Schmelze des Pulvers und die Schmelze der angrenzenden bereits erstarrten festen Kontur, die zuvor aufgeschmolzen wurde und unter der nachträglich aufgetragenen Pulverschicht liegt, zu einem gemeinsamen Schmelzbad aufgeschmolzen. Daraufhin geht das Schmelzbad eine schmelzmetallurgische Verbindung ein.

So bildet sich nach der Erstarrung ein homogener Formkörper mit hoher Festigkeit und Dichtigkeit und ohne Rillen oder sonstige Übergangsstellen aus, was einer monolithischen Struktur gleichzusetzen ist.

Wurde auf diese Weise der Mikrokühlkörper vollständig aufgebaut, so ist es anschließend lediglich notwendig, das im Inneren der Mikrokühlstruktur 3 zurückgebliebene Pulver zu entfernen. Dies kann beispielsweise mittels Druckluft erreicht werden oder indem der Mikrokühlkörper anschließend mit Wasser unter Druck durchspült wird. Anschließend wird an der Montagefläche 2 eine Isolierschicht angebracht, indem sie mit der Montagefläche 2 des Mikrokühlkörpers 1 über eine wärmeleitende Klebeschicht 8 verbunden wird.

Schließlich ist es möglich, mittels Siebdruckverfahren, Inkjetverfahren oder Dispersionsverfahren elektrisch leitfähigen Strukturen in die Isolierschicht 7 oder auf die Keramik aufzubringen.

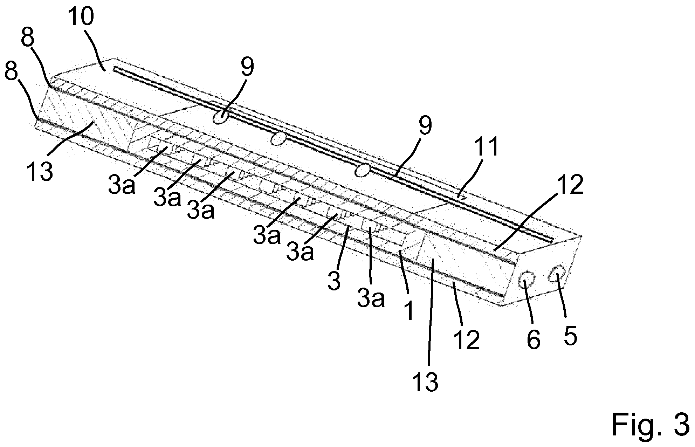

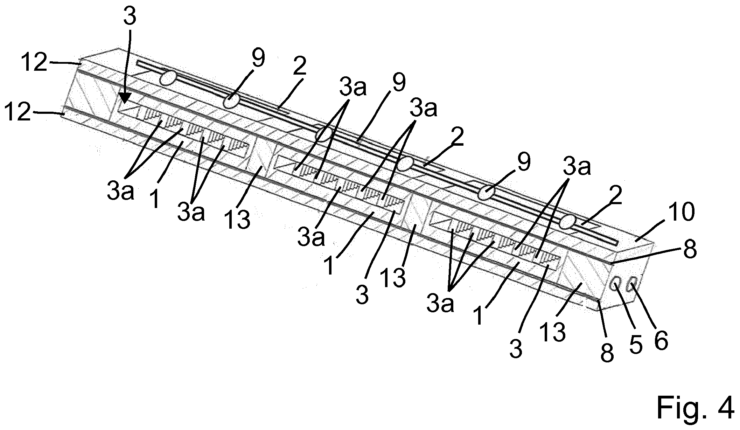

Der Mikrokühlkörper 1 ist quaderartig aufgebaut, um in einer dünneren Ausführung (0,8mm) in eine Platine 10 eingesetzt werden zu können. Die in den Figuren 3 und 4 näher gezeigte Platine 10 ist aus zwei Leiterplattenelementen 12 zusammengesetzt, die die Isolierschicht 7 bilden. Zwischen die Leiterplatten 12 sind mehrere Mikrokühlkörper 1 eingesetzt, die jeweils über eine Klebeschicht 8 mit den Leiterplatten 12 verbunden sind, wobei nicht eingenommene Bereiche zwischen den Mikrokühlkörpern mittels eines Füllmaterials 13 aufgefüllt sind. Diese weist dazu Aussparungen auf, in der wie hier gezeigt drei Mikrokühlkörper 1 eingesetzt sind. Im Anschluss wird die Platine mit der Isolierschicht 7 überdeckt. Die Isolierschicht 7 überdeckt in dem vorliegenden Ausführungsbeispiel die drei Mikrokühlkörper 1 vollständig.

Wie in Figur 4 gezeigt werden zur Kühlung mehrere Mikrokühlkörper 1 zwischen mindestens zwei Isolierschichten 7 eingesetzt. Auch hier werden die Zwischenräume mit einem Füllmaterial aufgefüllt.

Die Mikrokühlkörper 1 haben bei gleicher Dicke unterschiedliche Formen. Bei unterschiedlichen Dicken werden in einem nicht dargestellten Ausführungsbeispiel durch das Füllmaterial 13 die vorhandenen Höhenunterschiede der Mikrokühlkörper 1 ausgeglichen.

In einem weiteren alternativen nicht dargestellten Ausführungsbeispiel werden Bauteile, welche bereits über eine Isolierung verfügen direkt auf den Mikrokühlkörper 1 aufgebracht. Hierzu wird in die Montagefläche 2 eine entsprechende Aussparung in die Isolierschicht 7 eingebracht.

In einem weiteren, nicht dargestellten Ausführungsbeispiel ist es auch möglich, die Mikrokühlkörper 1 nur teilweise mit der Isolierschicht 7, insbesondere der Keramik zu versehen. Die Montagefläche 2 des Mikrokühlkörpers 1 kann alternativ auch allein als Befestigungsbasis für die erfindungsgemäße Isolierschicht 7 dienen. In diesem Falle ist die Isolierschicht 7 als Keramik ausgebildet. Diese wird unter einem Druck zwischen 150 bar und 200 bar, bevorzugt von 200 bar und einer Temperatur zwischen 60°C und 90°C bevorzugt 70°C aufgebracht.

Die Keramik ist aus Glaskeramik und einem Bindemittel gebildet, wobei die Glaskeramik in eine Bindemittelmatrix eingebettet wird, welche nach Aufbringen auf den Mikrokühlkörper 1 einem Brennvorgang in einer Brennkammer unterzogen wird und bei einer Temperatur zwischen 700°C und 1000°C, bevorzugt zwischen 850°C und 900°C gebrannt wird. Bei den genannten Temperaturen entweicht das Bindemittel aus der Matrix nahezu vollständig und es verbleibt eine Glaskeramik.

### Bezugszeichenliste

- 1: Mikrokühlkörper
- 2: Montagefläche
- 3: Mikrostruktur
- 3a: Stabrippen
- 4: Verbindungskanäle
- 4a: Ovale Wandungen und Grenzflächen
- 5: Zulauföffnung
- 6: Ablauföffnung
- 7: Isolierschicht
- 8: Klebeschicht
- 9: elektrisch leitfähige Strukturen
- 10: Platine
- 11: Kühlabschnitt
- 12: Leiterplatte
- 13: Füllmaterial

## Patentansprüche

1. Mikrokühlkörper (1) mit mindestens einer Montagefläche (2) für ein zu kühlendes Bauteil, insbesondere ein Halbleiterbauelement, welcher im Inneren eine Mikrokühlstruktur (3) aufweist, die über Verbindungskanäle (4) mit mindestens einer Zulauföffnung (5) und mindestens einer Ablauföffnung (6) verbunden ist und mit diesen ein innerhalb des Mikrokühlkörpers ausgebildeten Kühlkreislauf bilden, über den der Mikrokühlstruktur (3) ein Kühlmedium zuführbar beziehungsweise aus ihr abführbar ist, wobei der Mikrokühlkörper (1) eine monolithische Struktur aufweist, **dadurch gekennzeichnet, dass** an der Montagefläche (2) eine Isolierschicht (7) vorgesehen ist, die mittels einer Klebeschicht (8) mit der Montagefläche (2) verbunden ist.

2. Mikrokühlkörper (1) nach Anspruch 1, **dadurch gekennzeichnet, dass** die Isolierschicht (7) aus einer Glaskeramik, einem keramik-gefüllten Kunststoff, PTFE oder glasfaserverstärktem Kunststoff auf Epoxidbasis gebildet ist.

3. Mikrokühlkörper (1) nach Anspruch 1, **dadurch gekennzeichnet, dass** die Isolierschicht (7) durch eine Keramik gebildet ist.

4. Mikrokühlkörper (1) nach einem der vorhergehenden Ansprüche, **dadurch gekennzeichnet, dass** die Isolierschicht (7) auflaminiert ist und elektrisch leitfähige Strukturen (9) aufweist, welche mittels Siebdruck, Inkjekt- oder Dispensionsverfahren auf die Isolierschicht (7) aufgebracht sind.

5. Platine (10), insbesondere Hochfrequenzplatine, welche mindestens einen Kühlabschnitt (11) mit mindestens einem Mikrokühlkörper (1) nach einem der vorhergehenden Ansprüche aufweist.

6. Platine (10) nach Anspruch 5, **dadurch gekennzeichnet, dass** sie eine Isolierschicht (7) mit einer Dicke zwischen 12 µm und 1000 µm, bevorzugt 75 µm bis 500 µm, noch bevorzugter eine Schichthöhe von 200 µm aufweist.

7. Platine (10) nach Anspruch 5 oder 6, **dadurch gekennzeichnet, dass** die Isolierschicht sich an der Montagefläche (2) um den Kühlabschnitt (11) herum erstreckt.

8. Platine (10) nach einem der Ansprüche 5 oder 6, **dadurch gekennzeichnet, dass** die Isolierschicht (7) den Mikrokühlkörper (1) vollständig oder nahezu vollständig überdeckt.

9. Platine (10) nach Anspruch 5 bis 7, **dadurch gekennzeichnet, dass** der Mikrokühlkörper (1) zur Bildung des Kühlabschnittes (11) der Platine (10) von einem Material mit kleiner oder geringer Wärmeleitfähigkeit, insbesondere aus keramik-gefülltem Kunststoff, PTFE oder glasfaserverstärktem Kunststoff auf Epoxidbasis umgeben ist.

10. Platine (10) nach einem der Ansprüche 5 bis 9, **dadurch gekennzeichnet, dass** die Mikrokühlstruktur (3) innerhalb des Mikrokühlkörpers (1) durch Stabrippen (3a) gebildet ist, welche quer zu einer Strömungsrichtung innerhalb der Mikrokühlstruktur (3) ausgerichtet sind.

11. Platine (10) nach einem der Ansprüche 5 bis 10, **dadurch gekennzeichnet, dass** die Zulauföffnung (5) eine vergrößerte Höhe zwischen 200 und 1000 µm, bevorzugt 500 µm aufweist.

12. Platine (10) nach einem der vorherigen Ansprüche 5 bis 11, **dadurch gekennzeichnet, dass** der Mikrokühlkörper (1) aus Nickel, Kupfer, Edelstahl oder Molybdän gebildet ist.

13. Diodenlaserbauelement mit mindestens einer Platine nach einem der Ansprüche 6 bis 12.

14. Verfahren zur Herstellung eines Mikrokühlkörpers (1) nach einem der vorherigen Ansprüche, **dadurch gekennzeichnet, dass** es die Schritte umfasst
Herstellung des Mikrokühlkörpers (1) mittels des selektiven Laserschmelzens zur Bildung einer monolithischen Struktur;
Aufbringen einer Isolierschicht (7) auf die mindestens eine Montagefläche (2) des Mikrokühlkörpers (1) mittels einer wärmeleitenden Klebeschicht (8); und
Aufbringen von elektrisch leitfähigen Strukturen auf die Isolierschicht (7) mittels Siebdruck, Inkjekt-Verfahren oder Dispensionsverfahren.

15. Verfahren zur Herstellung einer Platine (10) nach einem der Ansprüche 1 bis 12, **dadurch gekennzeichnet, dass** die Isolierschicht (7) als Keramik ausgebildet und aus Glas, Keramik und Bindemittel gebildet wird und unter einem Druck zwischen 150 bar und 300 bar, bevorzugt von 230 bar, und einer Temperatur zwischen 60 °C und 200°C, bevorzugt 140 °C aufgebracht wird, , wobei Glas und Keramik in eine Bindemittelmatrix eingebettet werden, und die Platine (10) einem Brennvorgang unterzogen wird, in dem sie bei einer Temperatur zwischen 600°C und 1.000 °C, bevorzugt zwischen 700 °C gebrannt wird.
